# EUROPEAN PATENT APPLICATION

(11) **EP 4 819 202 A1**
(43) Date of publication of application: **07.10.2026**
(21) Application number: 24897611.0
(22) Date of filing: 27.11.2024
(51) Int. Cl.: H01L 23/32, H01L 23/12, H01L 23/14, H01L 23/15, H05K 1/09, H05K 3/46

(54) **COMPOSITE WIRING BOARD AND SEMICONDUCTOR DEVICE**

(30) Priority: 30.11.2023 JP 2023202697
(71) Applicant: Kyocera Corporation, Kyoto-shi, Kyoto 612-8501 (JP)
(72) Inventor: ITOU, Seiichirou, Kyoto-shi, Kyoto 612-8501 (JP); GONDO, Iori, Kyoto-shi, Kyoto 612-8501 (JP); HARAZONO, Masaaki, Kirishima-shi, Kagoshima 899-4312 (JP)
(74) Representative: Viering, Jentschura & Partner mbB Patent- und Rechtsanwälte
(86) International application number: PCT/JP2024/042050
(87) International publication number: WO 2025/115927

(57) **Abstract**

A composite wiring board according to the present disclosure includes a base board, a bonding material of a melting-point-change type, and an interconnect board that is electrically connected to the base board via the bonding material. The base board includes a first core base member, a first organic base member that is bonded to the first core base member and is made of an organic resin, and a plurality of first wiring lines that are located inside the first organic base member. The interconnect board includes a second organic base member that is made of an organic resin, and a plurality of second wiring lines that are located inside the second organic base member. The second wiring line includes a diffusion suppression layer on a side surface thereof.

## Description

### TECHNICAL FIELD

The present disclosure relates to a composite wiring board and a semiconductor device.

### BACKGROUND OF INVENTION

In the related art, a technique is known in which a plurality of semiconductor elements are mounted on a single base board via an interconnect board referred to as an interposer.

Patent Document 1 discloses a composite wiring board in which an FC-BGA board and an interposer are bonded via a bonding material such as solder. In the FC-BGA board, a base member made of an organic resin and including a metal wiring line formed therein is bonded to a core base member made of glass cloth. The interposer is made of an organic resin, and includes a metal wiring line formed therein.

### CITATION LIST

### PATENT LITERATURE

Patent Document 1: JP 2023-083003 A

### SUMMARY

In the present disclosure, a composite wiring board includes a base board, a bonding material of a melting-point-change type, and an interconnect board that is electrically connected to the base board via the bonding material. The base board includes a first core base member, a first organic base member that is bonded to the first core base member and is made of an organic resin, and a plurality of first wiring lines that are located inside the first organic base member. The interconnect board includes a second organic base member that is made of an organic resin, and a plurality of second wiring lines that are located inside the second organic base member. The second wiring line includes a diffusion suppression layer on a side surface of the second wiring line.

### BRIEF DESCRIPTION OF THE DRAWINGS

FIG. 1 is a schematic cross-sectional view illustrating a configuration of a semiconductor device according to an embodiment.
FIG. 2 is a schematic cross-sectional view illustrating a configuration of a base board according to an embodiment.
FIG. 3 is a schematic enlarged view of a region III illustrated in FIG. 2.
FIG. 4 is a schematic cross-sectional view illustrating a configuration of an interconnect board according to an embodiment and a periphery thereof.
FIG. 5 is a schematic enlarged view of a region V illustrated in FIG. 4.
FIG. 6 is a schematic view for describing a method for manufacturing a second organic base member according to an embodiment.
FIG. 7 is a schematic view for describing the method for manufacturing the second organic base member according to the embodiment.
FIG. 8 is a schematic view for describing the method for manufacturing the second organic base member according to the embodiment.
FIG. 9 is a schematic view for describing the method for manufacturing the second organic base member according to the embodiment.
FIG. 10 is a schematic view for describing the method for manufacturing the second organic base member according to the embodiment.
FIG. 11 is a schematic view for describing the method for manufacturing the second organic base member according to the embodiment.
FIG. 12 is a schematic view for describing the method for manufacturing the second organic base member according to the embodiment.

### DESCRIPTION OF EMBODIMENTS

Modes (hereinafter, referred to as "embodiments") for implementing a composite wiring board and a semiconductor device according to the present disclosure are described in detail below with reference to the drawings. Note that the present disclosure is not limited by the embodiments. The embodiments can be appropriately combined within a range that does not cause inconsistencies in the processing content. In the following embodiments, the same portions are denoted by the same reference signs, and redundant descriptions are omitted.

In the following embodiments, expressions such as "certain", "orthogonal", "perpendicular", and "parallel" may be used, but these expressions need not mean exactly "certain", "orthogonal", "perpendicular", and "parallel". In other words, each of the expressions described above allows for deviations in, for example, manufacturing accuracy, or installation accuracy.

In the drawings to be referenced below, to facilitate understanding, an orthogonal coordinate system may be defined, in which the X-axis direction, Y-axis direction, and Z-axis direction mutually orthogonal are specified, and the Z-axis positive direction is set as the vertically upward direction.

When a difference is present between a coefficient of thermal expansion of a base board and a coefficient of thermal expansion of an interconnect board, distortion may occur in a bonding material due to a difference in thermal expansion between the base board and the interconnect board when the base board and the interconnect board are bonded by using the bonding material in a manufacturing process. The distortion of the bonding material may reduce connection reliability between the base board and the interconnect board. In a subsequent cooling process, a crack may occur in the bonding material due to a difference in thermal contraction between the base board and the interconnect board. As a result, connection reliability between the base board and the interconnect board may also be degraded.

Note that the difference in the coefficient of thermal expansion between the base board and the interconnect board may occur due to, for example, a difference between a ratio of a metal wiring line in a base member made of an organic resin included in the base board and a ratio of a metal wiring line in the interconnect board. In general, a solid pattern such as a ground wiring line or a power supply wiring line is arranged in the base member made of an organic resin included in the base board, whereas a solid pattern is rarely arranged in the interconnect board. Therefore, due to the difference in the ratio of the metal wiring line, the coefficient of thermal expansion of the interconnect board is higher than the coefficient of thermal expansion of the base board.

The present disclosure provides a technique capable of improving connection reliability between the base board and the interconnect board.

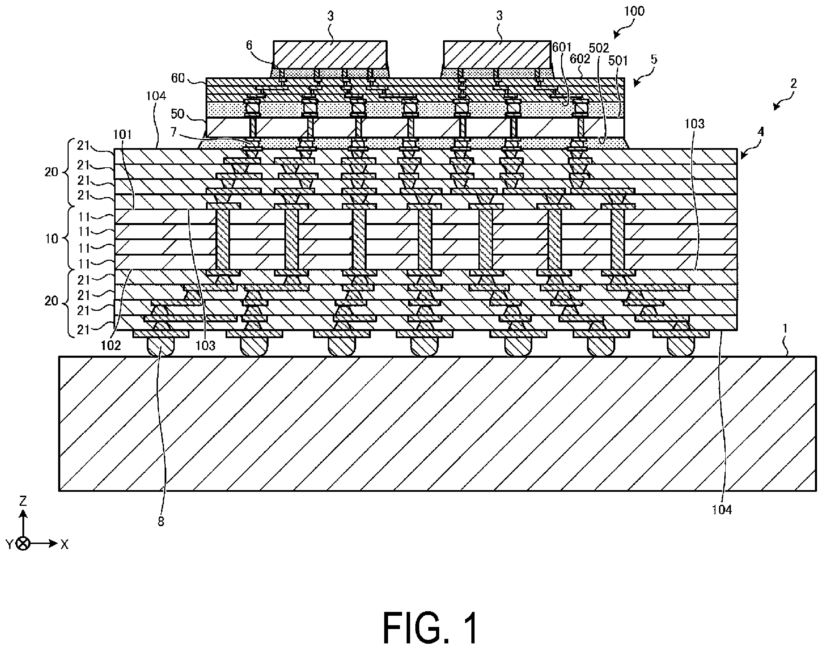

First, a configuration of a semiconductor device 100 according to an embodiment is described with reference to FIG. 1. FIG. 1 is a schematic cross-sectional view of the semiconductor device 100 according to the embodiment.

As illustrated in FIG. 1, the semiconductor device 100 includes a mother board 1, a composite wiring board 2, and a plurality of semiconductor elements 3.

The composite wiring board 2 includes a base board 4 and an interconnect board 5.

The base board 4 is mounted over the mother board 1. Details of the base board 4 are described later.

The interconnect board 5 is a so-called interposer. The interconnect board 5 interconnects electrical connection between the base board 4 and the semiconductor element 3. The interconnect board 5 is bonded to the semiconductor element 3 via a bonding material 6, and is bonded to the base board 4 via a bonding material 7.

The Young's modulus of the interconnect board 5 may be smaller than the Young's modulus of the base board 4. In this case, the interconnect board 5 may have flexibility that allows the interconnect board 5 to be deformed according to the shape of the surface of the base board 4. The bonding materials 6 and 7 are, for example, solder. Details of the interconnect board 5 and the bonding material 7 are described later.

The semiconductor element 3 is mounted over the interconnect board 5. The semiconductor element 3 is, for example, a chip or a chiplet in which a circuit or an element is formed on a board made of a material other than a semiconductor, such as a semiconductor chip or a glass board. A chiplet is a functional block constituting a part of an integrated circuit of the semiconductor device 100.

Although FIG. 1 illustrates two semiconductor elements 3, the semiconductor device 100 may include three or more semiconductor elements 3. The semiconductor device 100 may include only one semiconductor element 3. For example, when the semiconductor element 3 is a chiplet, an integrated circuit having one function may be configured by the plurality of semiconductor elements 3.

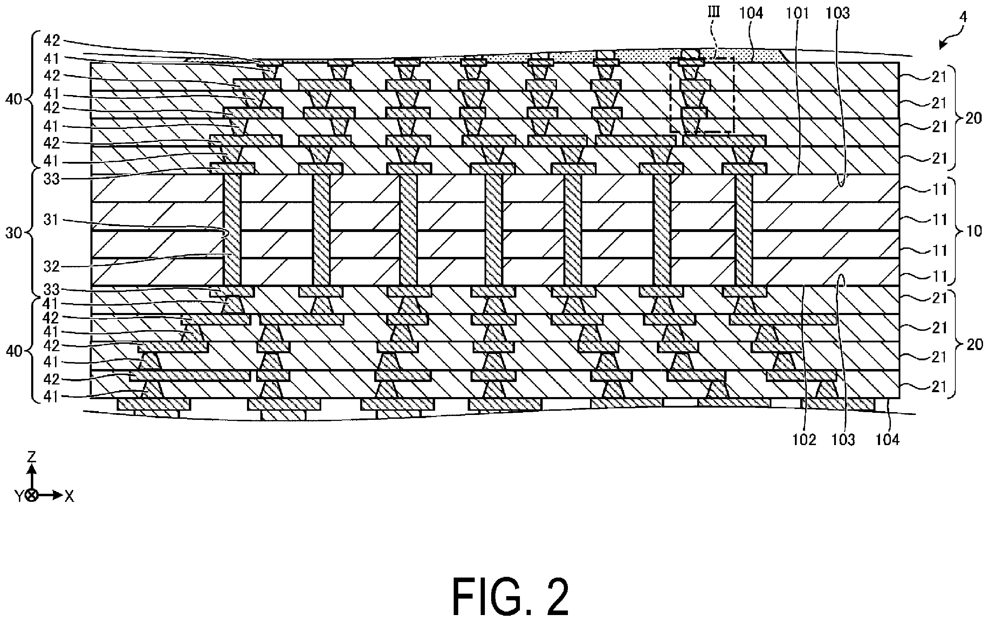

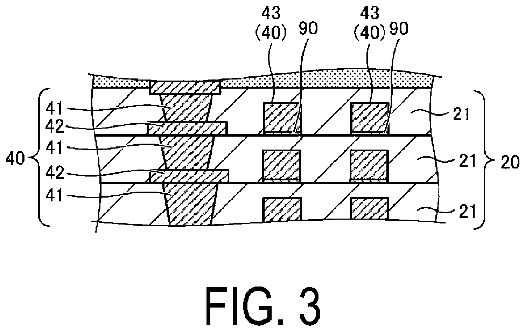

The configuration of the base board 4 according to the embodiment is described with reference to FIG. 2 and FIG. 3. FIG. 2 is a schematic cross-sectional view illustrating the configuration of the base board 4 according to the embodiment. FIG. 3 is a schematic enlarged view of a region III illustrated in FIG. 2.

The base board 4 includes a first core base member 10 and a first organic base member 20. The base board 4 is a laminate body of the first core base member 10 and the first organic base member 20. The base board 4 includes a first conductor portion 30 and a second conductor portion 40.

### First Core Base Member

The first core base member 10 is a base member made of ceramic. The first core base member 10 may be formed using a ceramic composite material containing a glass component, so-called glass ceramic. The glass ceramic may be any one of a composite of a glass phase and ceramic particles, a composite of a glass phase and a crystal phase formed by crystallization of a part of the glass phase, a form in which ceramic particles are present in a glass phase, and a form in which a glass phase is present at a grain boundary between ceramic particles. The first core base member 10 formed using ceramic in this manner has a higher rigidity than a core material made of glass.

For example, the first core base member 10 may be low temperature co-fired ceramics (LTCC). When LTCC is used as the first core base member 10, a metal having a low melting point, such as copper or silver having a relatively low electric resistance, can be used as the wiring line. In the present embodiment, the metal having a low melting point is a metal having a lower melting point than a general metal used for a wiring line of a ceramic base member, for example, tungsten or molybdenum.

The first core base member 10 may contain a ceramic filler as the ceramic particles. As the ceramic filler, for example, alumina (aluminum oxide), calcium titanate, magnesium titanate, or the like can be used. In particular, the first core base member 10 containing alumina has a high rigidity.

The first core base member 10 includes a first surface 101 and a second surface 102 located opposite to the first surface 101. The first core base member 10 may be a plate-shaped body including the first surface 101 and the second surface 102 as main surfaces.

In the embodiment, the first core base member 10 includes a plurality of ceramic layers 11. The plurality of ceramic layers 11 are layered along the thickness direction of the first core base member 10. The base board 4 including such a first core base member 10 has a high degree of freedom in design. By configuring the first core base member 10 using the plurality of ceramic layers 11, the first core base member 10 can be produced while checking whether the first conductor portion 30 is appropriately formed for each layer. Thus, the yield of the first core base member 10 can be improved.

In the example illustrated in FIG. 1 and FIG. 2, the first core base member 10 includes four ceramic layers 11. However, the number of the ceramic layers 11 is not limited to four. The number of the ceramic layers 11 may be two or three, or may be five or more.

### First Organic Base Member

The first organic base member 20 is a base member containing an organic component. The organic component may be an organic resin. The organic resin may be, for example, an epoxy resin, an acrylic resin, a polycarbonate resin, a polyimide resin, an olefin resin, a polyphenylene resin, or the like.

The organic resin may be, for example, polytetrafluoroethylene (PTFE) or other fluororesin, or polyphenylene ether resin. The first organic base member 20 may contain a component other than the organic resin. Note that, in the present disclosure, the organic resin may be, for example, a material that accounts for 30 mass% or more of the material constituting the first organic base member 20.

The first organic base member 20 includes a third surface 103 and a fourth surface 104 located opposite to the third surface 103. The first organic base member 20 may be a plate-shaped body including the third surface 103 and the fourth surface 104 as main surfaces.

The base board 4 according to the embodiment includes two first organic base members 20. One of the two first organic base members 20 is bonded to the first surface 101 of the first core base member 10, and the other thereof is bonded to the second surface 102 of the first core base member 10.

The first organic base member 20 located on the first surface 101 of the first core base member 10 includes the third surface 103 bonded to the first surface 101 of the first core base member 10, and the plurality of semiconductor elements 3 are placed on the fourth surface 104 of the first organic base member 20 via the interconnect board 5 (see FIG. 1).

The first organic base member 20 located on the second surface 102 of the first core base member 10 includes the third surface 103 bonded to the first surface 101 of the first core base member 10, and the fourth surface 104 of the first organic base member 20 is bonded to the mother board 1 via a bonding material 8 (see FIG. 1).

The first organic base member 20 includes a plurality of organic resin layers 21. The plurality of organic resin layers 21 are layered along the thickness direction of the first organic base member 20. The base board 4 including such a first organic base member 20 has a high degree of freedom in design. In the example illustrated in FIG. 2, the first organic base member 20 includes four organic resin layers 21. However, the number of the organic resin layers 21 is not limited to four. The number of the organic resin layers 21 may be two or three, or may be five or more.

In the example illustrated in FIG. 1 and FIG. 2, the base board 4 includes the first organic base member 20 on each of the main surfaces (the first surface 101 and the second surface 102) of the first core base member 10. The base board 4 is not limited thereto, and may include the first organic base member 20 on at least the first surface 101 of the first core base member 10.

The first organic base member 20 containing an organic component is more likely to form a fine wiring pattern than an inorganic board. On the other hand, the first core base member 10 made of ceramic has a higher rigidity than the first organic base member 20 and a lower density than the first organic base member 20.

The base board 4 according to the embodiment can increase the rigidity while achieving miniaturization and a narrow pitch of the wiring line by combining the first core base member 10 and the first organic base member 20. Since the warpage of the board is more likely to be actualized as the board becomes larger, the configuration of the base board 4 in which the low rigidity of the first organic base member 20 is compensated for by the first core base member 10 is particularly useful in increasing the size of the board.

The first core base member 10 and the first organic base member 20 are bonded to each other by, for example, hydrogen bonding. Specifically, the first core base member 10 and the first organic base member 20 are bonded to each other by bonding the hydroxyl groups of the first core base member 10 and the first organic base member 20 to each other. In this case, a ceramic material such as alumina having a surface hydroxyl group may be used for the first core base member 10, and an epoxy resin, which is a resin material including a hydroxyl group, may be used for the first organic base member 20. In this manner, the first core base member 10 and the first organic base member 20 are directly bonded to each other without solder, underfill, or the like interposed therebetween. With this, the thickness of the base board 4 can be suppressed, and the manufacturing process can be facilitated.

The first core base member 10 may contain a glass component, and the first organic base member 20 may contain a coupling agent that is chemically bonded to the glass component. As the coupling agent, for example, a silane coupling agent can be used. As the coupling agent, a titanium-based coupling agent or an aluminum-based coupling agent can also be used. According to such a configuration, the first core base member 10 and the first organic base member 20, which are different materials, can be more firmly bonded to each other by chemically bonding the first core base member 10 and the first organic base member 20.

### First Conductor Portion

The first conductor portion 30 is a through-hole conductor located in the first core base member 10. Specifically, the first conductor portion 30 includes a through hole 31 that penetrates the first core base member 10, and a conductor 32. The conductor 32 includes metal as a main component, and is located inside the through hole 31.

The first conductor portion 30 includes a land 33 on the first surface 101 and the second surface 102 of the first core base member 10.

### Second Conductor Portion

The second conductor portion 40 includes a plurality of vias 41, a plurality of lands 42, and a plurality of first wiring lines 43. The via 41 penetrates one or more organic resin layers 21. The land 42 is located between the adjacent organic resin layers 21, and electrically connects the plurality of vias 41. The first wiring line 43 is located inside the first organic base member 20. The first wiring line 43 located in the first organic base member 20 bonded to the first surface 101 of the first core base member 10 and the first wiring line 43 located in the first organic base member 20 bonded to the second surface 102 are electrically connected via the conductor 32 penetrating the first core base member 10. With this, the first wiring line 43 can be made denser. Note that details of the first wiring line 43 are described later.

For example, the first conductor portion 30 and the second conductor portion 40 may be metal conductors containing copper or silver as a main component. For example, both the first conductor portion 30 and the second conductor portion 40 may be metal conductors containing copper as a main component. Both the first conductor portion 30 and the second conductor portion 40 may be metal conductors containing silver as a main component. One of the first conductor portion 30 and the second conductor portion 40 may be a metal conductor containing copper as a main component, and the other thereof may be a metal conductor containing silver as a main component.

By using a metal conductor containing copper or silver as a main component for all of the first conductor portion 30 and the second conductor portion 40, high electrical characteristics can be obtained as compared to a case where, for example, one of the first conductor portion 30 and the second conductor portion 40 is a metal conductor other than copper and silver.

Out of the first conductor portion 30 and the second conductor portion 40, only the first conductor portion 30 may contain a glass component. In this case, the first conductor portion 30 is firmly bonded to the first core base member 10, which also contains a glass component, via the glass component. Thus, the rigidity of the first core base member 10 can be increased.

In a firing step in the production of the base board 4, the shrinkage rates of the first core base member 10 and the first conductor portion 30 can be made uniform to some extent, which can reduce the likelihood of a position shift of the first conductor portion 30.

The first conductor portion 30 may be formed by, for example, printing a conductor paste containing copper and a glass component on a green sheet that is a raw material of the ceramic layer 11 and simultaneously firing the conductor paste and the green sheet. Specifically, the conductor paste may contain, for example, copper powder, borosilicate glass powder, and silica particles.

On the other hand, the second conductor portion 40 may be formed by copper plating. With this, out of the first conductor portion 30 and the second conductor portion 40, only the first conductor portion 30 can be configured to contain a glass component.

The second conductor portion 40 may be electrically and thermally connected to the semiconductor element 3 via the interconnect board 5. The second conductor portion 40 containing copper or silver having a relatively high thermal conductivity as a main component is thermally connected to the semiconductor element 3 serving as a heat source. With this, heat generated from the semiconductor element 3 can be efficiently released via the second conductor portion 40 and the first conductor portion 30.

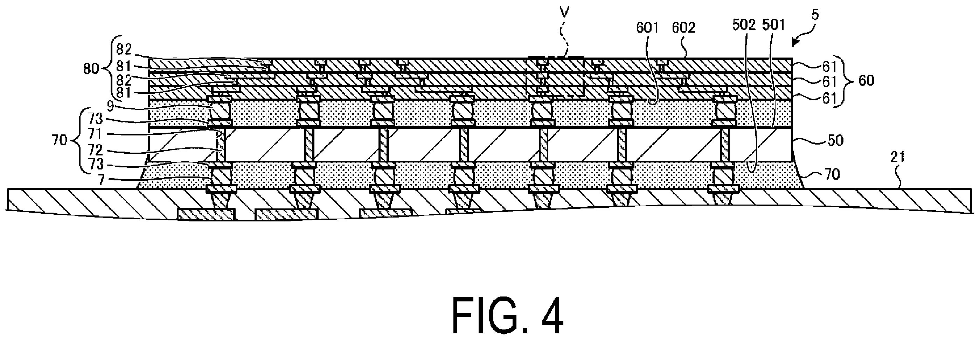

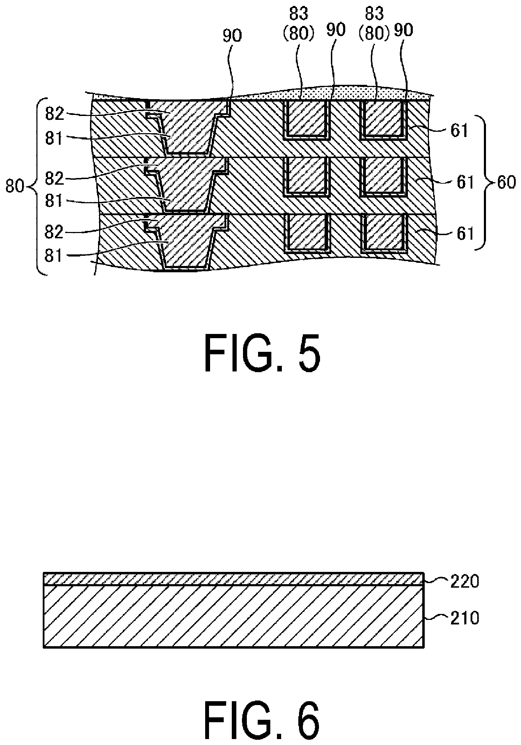

The configuration of the interconnect board 5 according to the embodiment is described with reference to FIG. 4 and FIG. 5. FIG. 4 is a schematic cross-sectional view illustrating the configuration of the interconnect board 5 according to the embodiment and the periphery thereof. FIG. 5 is a schematic enlarged view of a region V illustrated in FIG. 4.

The interconnect board 5 includes a second core base member 50 and a second organic base member 60. The interconnect board 5 is a laminate body of the second core base member 50 and the second organic base member 60. The interconnect board 5 includes a third conductor portion 70 and a fourth conductor portion 80.

### Second Core Base Member

The second core base member 50 is a base member made of ceramic. The second core base member 50 may be formed using a ceramic composite material containing a glass component, so-called glass ceramic. The glass ceramic may be any one of a composite of a glass phase and ceramic particles, a composite of a glass phase and a crystal phase formed by crystallization of a part of the glass phase, a form in which ceramic particles are present in a glass phase, and a form in which a glass phase is present at a grain boundary between ceramic particles. The second core base member 50 formed using ceramic in this manner has a higher rigidity than a core material made of glass.

For example, the second core base member 50 may be low temperature co-fired ceramics (LTCC). When LTCC is used as the second core base member 50, a metal having a low melting point, such as copper or silver having a relatively low electric resistance, can be used as the wiring line.

The second core base member 50 may contain a ceramic filler as the ceramic particles. As the ceramic filler, for example, alumina (aluminum oxide), calcium titanate, magnesium titanate, or the like can be used. In particular, the second core base member 50 containing alumina has a high rigidity.

The second core base member 50 includes a fifth surface 501 and a sixth surface 502 located opposite to the fifth surface 501. The second core base member 50 may be a plate-shaped body including the fifth surface 501 and the sixth surface 502 as main surfaces.

Note that the interconnect board 5 according to the present embodiment may include at least the second organic base member 60, and is not necessarily required to include the second core base member 50.

### Second Organic Base Member

The second organic base member 60 is a base member containing an organic component. The organic component may be an organic resin. The organic resin may be, for example, an epoxy resin, an acrylic resin, a polycarbonate resin, a polyimide resin, an olefin resin, a polyphenylene resin, or the like.

The organic resin may be, for example, polytetrafluoroethylene (PTFE) or other fluororesin, or polyphenylene ether resin. The second organic base member 60 may contain a component other than the organic resin. Note that, in the present disclosure, the organic resin may be, for example, a material that accounts for 30 mass% or more of the material constituting the second organic base member 60.

The second organic base member 60 includes a seventh surface 603 and an eighth surface 604 located opposite to the seventh surface 603. The second organic base member 60 may be a plate-shaped body including the seventh surface 603 and the eighth surface 604.

The second organic base member 60 includes the seventh surface 603 bonded to the fifth surface 501 of the second core base member 50 via a bonding material 9, and the plurality of semiconductor elements 3 is placed on the eighth surface 604 of the second organic base member 60 via the bonding material 6 (see FIG. 1).

The second organic base member 60 includes a plurality of organic resin layers 61. The plurality of organic resin layers 61 are layered along the thickness direction of the second organic base member 60. The interconnect board 5 including such a second organic base member 60 has a high degree of freedom in design. In the example illustrated in FIG. 4, the second organic base member 60 includes three organic resin layers 61. However, the number of the organic resin layers 61 is not limited to three. The number of the organic resin layers 61 may be one or two, or may be four or more.

### Third Conductor Portion

The third conductor portion 70 is a through-hole conductor located in the second core base member 50. Specifically, the third conductor portion 70 includes a through hole 71 that penetrates the second core base member 50, and a conductor 72. The conductor 72 contains metal as a main component, and is located inside the through hole 71.

The third conductor portion 70 includes a land 73 on the fifth surface 501 and the sixth surface 502 of the second core base member 50.

### Fourth Conductor Portion

The fourth conductor portion 80 includes a plurality of vias 81, a plurality of lands 82, and a plurality of second wiring lines 83. The via 81 penetrates one or more organic resin layers 61. The land 82 is located between the adjacent organic resin layers 61, and electrically connects the plurality of vias 81. The land 82 is formed integrally with the via 81 located in the same organic resin layer 61. The second wiring line 83 is located inside the second organic base member 60. Details of the second wiring line 83 are described later.

For example, the third conductor portion 70 and the fourth conductor portion 80 may be metal conductors containing copper or silver as a main component. For example, both the third conductor portion 70 and the fourth conductor portion 80 may be metal conductors containing copper as a main component. Both the third conductor portion 70 and the fourth conductor portion 80 may be metal conductors containing silver as a main component. One of the third conductor portion 70 and the fourth conductor portion 80 may be a metal conductor containing copper as a main component, and the other thereof may be a metal conductor containing silver as a main component.

By using a metal conductor containing copper or silver as a main component for all of the third conductor portion 70 and the fourth conductor portion 80, high electrical characteristics can be obtained as compared to a case where, for example, one of the third conductor portion 70 and the fourth conductor portion 80 is a metal conductor other than copper and silver.

Out of the third conductor portion 70 and the fourth conductor portion 80, only the first conductor portion 30 may contain a glass component. In this case, the third conductor portion 70 is firmly bonded to the second core base member 50, which also contains a glass component, via the glass component. Thus, the rigidity of the second core base member 50 can be increased.

In a firing step in the production of the interconnect board 5, the shrinkage rates of the second core base member 50 and the third conductor portion 70 can be made uniform to some extent, which can reduce the likelihood of a position shift of the third conductor portion 70.

The third conductor portion 70 may be formed by, for example, printing a conductor paste containing copper and a glass component on a green sheet that is a raw material of the second core base member 50 and simultaneously firing the conductor paste and the green sheet. Specifically, the conductor paste may contain, for example, copper powder, borosilicate glass powder, and silica particles.

On the other hand, the fourth conductor portion 80 may be formed by copper plating. With this, out of the third conductor portion 70 and the fourth conductor portion 80, only the third conductor portion 70 can be configured to contain a glass component.

The fourth conductor portion 80 may be electrically and thermally connected to the semiconductor element 3 via the bonding material 6. The fourth conductor portion 80 containing copper or silver having a relatively high thermal conductivity as a main component is thermally connected to the semiconductor element 3 serving as a heat source. With this, heat generated from the semiconductor element 3 can be efficiently released via the fourth conductor portion 80 and the third conductor portion 70.

In general, a solid pattern such as a ground wiring line or a power supply line is arranged in the first organic base member 20 of the base board 4, whereas a solid pattern is rarely arranged in the interconnect board 5. Thus, due to the difference in the ratio of the metal wiring line, the coefficient of thermal expansion of the interconnect board 5 is higher than the coefficient of thermal expansion of the base board 4. In another example, when the first core base member 10 of the base board 4 and the second core base member 50 of the interconnect board 5 are made of different materials, the coefficient of thermal expansion of the base board 4 and the coefficient of thermal expansion of the interconnect board 5 differ from each other. When the content rate of the inorganic material in the first organic base member 20 of the base board 4 and the content rate of the inorganic material in the second organic base member 60 of the interconnect board 5 are changed, the coefficient of thermal expansion of the base board 4 and the coefficient of thermal expansion of the interconnect board 5 differ from each other. When a difference is present between the coefficient of thermal expansion of the base board 4 and the coefficient of thermal expansion of the interconnect board 5, distortion may occur in the bonding material due to a difference in thermal expansion between the base board 4 and the interconnect board 5 when the base board 4 and the interconnect board 5 are bonded by using the bonding material in a manufacturing process. The distortion of the bonding material may degrade connection reliability between the base board 4 and the interconnect board 5.

In view of this, in the composite wiring board 2 according to the present embodiment, the bonding material 7 of a melting-point-change type is used as a bonding material that bonds the base board 4 and the interconnect board 5.

The bonding material 7 of a melting-point-change type is a bonding material whose melting point differs between an initial paste state and a state after being heated to become an intermetallic compound. Specifically, the bonding material 7 of a melting-point-change type is melted at a first melting point (for example, about 140 degrees Celsius), and thereafter has a second melting point (for example, about 245 degrees Celsius), which is higher than the first melting point, when remelted. The first melting point of the bonding material 7 of a melting-point-change type is lower than a melting point of a normal bonding material (lead-free solder, lead-containing solder, or the like). Therefore, when the bonding material 7 of a melting-point-change type is used, a difference in thermal expansion that occurs between the base board 4 and the interconnect board 5 in a step of bonding the base board 4 and the interconnect board 5 can be reduced, as compared with a case where a normal bonding material is used. With this, in the step described above, distortion is less likely to occur in the bonding material 7. A difference in thermal contraction between the base board 4 and the interconnect board 5 in the subsequent cooling process is also reduced, and hence cracks are less likely to occur in the bonding material 7. As described above, according to the composite wiring board 2 of the present embodiment, connection reliability between the base board 4 and the interconnect board 5 is improved.

The second melting point of the bonding material 7 of a melting-point-change type is higher than the first melting point. Specifically, the second melting point is higher than the melting point of the bonding material 6 used for bonding between the interconnect board 5 and the semiconductor element 3. Thus, even when the composite wiring board 2 is reheated in a step of melting the bonding material 6 and bonding the interconnect board 5 and the semiconductor element 3, the bonding material 7 (the melting-point-change type bonding material) that bonds the base board 4 and the interconnect board 5 is not remelted. Therefore, according to the composite wiring board 2 of the present embodiment, degradation of connection reliability between the base board 4 and the interconnect board 5 due to remelting of the bonding material 7 is less likely to occur.

As described above the first conductor portion 30 and the second conductor portion 40 of the base board 4 and the third conductor portion 70 and the fourth conductor portion 80 of the interconnect board 5 may contain copper as a main component. Specifically, the first wiring line 43 (see FIG. 3) of the base board 4 and the second wiring line 83 of the interconnect board 5 may contain copper as a main component. In this case, the bonding material 7 may contain at least one selected from the group consisting of Ag, Bi, In, Cu, and Sb, and Sn.

The coefficient of thermal expansion of the bonding material 7 of a melting-point-change type that contains at least one selected from the group consisting of Ag, Bi, In, Cu, and Sb, and Sn is close to the coefficient of thermal expansion of copper. That is, in the composite wiring board 2 according to the present embodiment, the coefficients of thermal expansion of the first wiring line 43 and the second wiring line 83 are close to the coefficient of thermal expansion of the bonding material 7. Thus, in the composite wiring board 2 according to the present embodiment, cracks are less likely to occur at bonding interfaces and the like due to a difference in thermal expansion between the first wiring line 43 and the second wiring line 83, and the bonding material 7. Therefore, according to the composite wiring board 2 according to the present embodiment, connection reliability between the base board 4 and the interconnect board 5 can be improved more.

As described above, the interconnect board 5 according to the present embodiment may include the second core base member 50. The coefficient of thermal expansion of the interconnect board 5 including the second core base member 50 is smaller than the coefficient of thermal expansion of the interconnect board 5 without the second core base member 50. Thus, the difference in the coefficient of thermal expansion between the interconnect board 5 including the second core base member 50 and the base board 4 is likely to occur. In the composite wiring board 2 according to the present embodiment, the bonding material 7 of a melting-point-change type is used as the bonding material 7 that bonds the base board 4 and the interconnect board 5. Thus, even when a difference in the coefficient of thermal expansion is present between the base board 4 and the interconnect board 5, a difference in thermal expansion that occurs between the base board 4 and the interconnect board 5 can be reduced in the step of bonding the base board 4 and the interconnect board 5. Based on the description given above, the composite wiring board 2 according to the present embodiment is effective as a configuration of the composite wiring board 2 including the interconnect board 5 with a core.

The configurations of the first wiring line 43 of the base board 4 and the second wiring line 83 of the interconnect board 5 according to the embodiment are described with reference to FIG. 3 and FIG. 5.

As illustrated in FIG. 5, the second wiring line 83 located inside the second organic base member 60 of the interconnect board 5 includes a diffusion suppression layer 90 on a side surface and a bottom surface thereof. In contrast, as illustrated in FIG. 3, the first wiring line 43 located inside the first organic base member 20 of the base board 4 may include the diffusion suppression layer 90 only on a bottom surface thereof. In other words, a side surface of the first wiring line 43 directly contacts with the first organic base member 20, and the diffusion suppression layer 90 is not present on the side surface of the first wiring line 43. On the other hand, the diffusion suppression layer 90 is present on the side surface of the second wiring line 83. An upper surface of the second wiring line 83 is located at the boundary part between the two adjacent organic resin layers 61 of the second organic base member 60.

The plurality of second wiring lines 83 located inside the second organic base member 60 are formed more finely than the plurality of first wiring lines 43 (see FIG. 3) located inside the first organic base member 20 of the base board 4. In terms of a distance between adjacent wiring lines in an in-plane direction of the base member (hereinafter, referred to as a "wiring-line distance"), the wiring-line distance between the second wiring lines 83 is shorter than the wiring-line distance between the first wiring lines 43. As the wiring-line distance is shorter, it is more difficult to secure insulation between the wiring lines. That is, it is more difficult to secure insulation between the second wiring lines 83 than between the first wiring lines 43. In contrast, the composite wiring board 2 according to the present embodiment includes the diffusion suppression layer 90 on the side surface of the second wiring line 83 having a short wiring-line distance. The diffusion suppression layer 90 suppresses diffusion of a metal component contained in the second wiring line 83 into the second organic base member 60. That is, in the composite wiring board 2 according to the present embodiment, the diffusion suppression layer 90 can suppress diffusion of a metal component contained in the second wiring line 83 into the second organic base member 60, and can reduce conduction between the adjacent second wiring lines 83 via the metal component diffusing into the second organic base member 60. That is, insulation reliability is high.

As illustrated in FIG. 5, a side surface and a bottom surface of the via 81 and a side surface of the land 82 may be provided with the diffusion suppression layer 90, similarly to the second wiring line 83.

The diffusion suppression layer 90 may contain any one of Cr, Ti, Ni, and a compound obtained by combining two or more of those. According to such a configuration, diffusion of metal contained in the second wiring line 83 into the second organic base member 60 can be reduced suitably.

### Method for manufacturing Second Organic Base Member

An example of a method for manufacturing the second organic base member 60 according to an embodiment, specifically, a method for forming the second wiring line 83 described above in the second organic base member 60 is described with reference to FIG. 6 to FIG. 12. FIG. 6 to FIG. 12 are schematic views for describing the method for manufacturing the second organic base member 60 according to the embodiment. For example, in the second organic base member 60, three insulation layers (the organic resin layers 61) are layered.

As illustrated in FIG. 6, a release layer 220 is formed on one surface of a support body 210. The release layer 220 may be irradiated with light through the support body 210, and hence the support body 210 preferably has translucency. For example, a glass plate can be used as the support body 210. The material of the release layer 220 may be a resin that absorbs ultraviolet light (UV light) and becomes releasable.

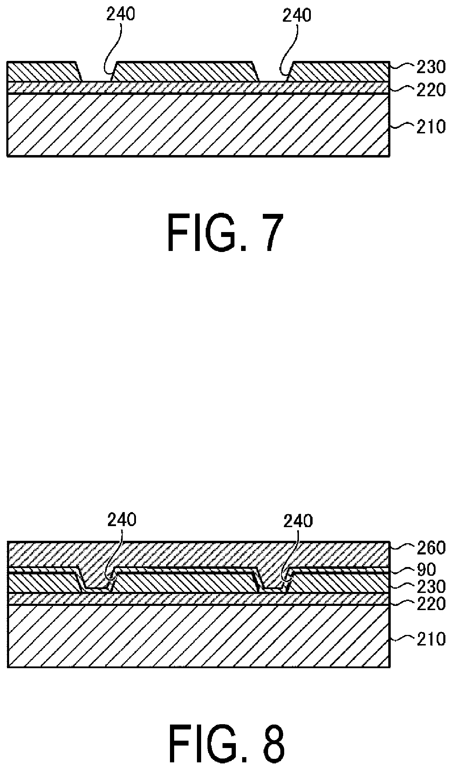

As illustrated in FIG. 7, an insulating resin layer 230 is formed on the release layer 220, and then a through hole 240 that penetrates the insulating resin layer 230 in a thickness direction thereof is formed by laser machining.

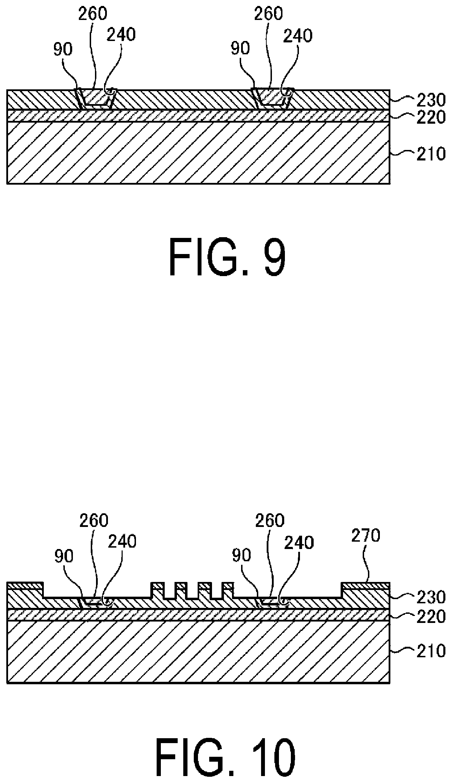

As illustrated in FIG. 8, the diffusion suppression layer 90 is formed on a surface of the insulating resin layer 230 in which the through hole 240 is formed, and then is subjected to electrolytic copper plating. Then, as illustrated in FIG. 9, the surface is polished to remove excessive copper plating 260.

As illustrated in FIG. 10, after a mask layer 270 is formed on the surface by using titanium or the like, portions other than the mask layer 270 are subjected to dry etching.

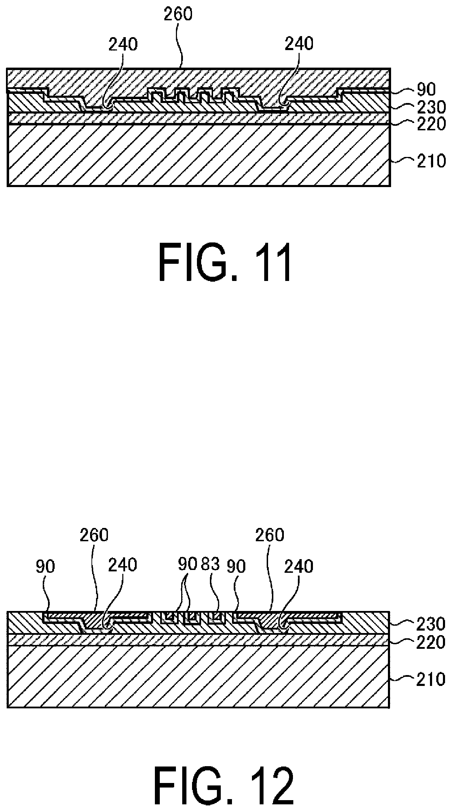

As illustrated in FIG. 11, the diffusion suppression layer 90 is formed again on the surface after etching, and then is subjected to electrolytic copper plating. Then, as illustrated in FIG. 12, the surface is polished to remove excessive copper plating 260. As a result, the second wiring line 83 in which the diffusion suppression layer 90 is located on the side surface and the bottom surface is formed.

The steps in FIG. 6 to FIG. 12 described above are repeated (three times in this example), and thus the second organic base member 60 is produced.

Note that the present technique can also include the following configurations.
(1) A composite wiring board (the composite wiring board 2 as an example) includes a base board (the base board 4 as an example), a bonding material of a melting-point-change type (the bonding material 7 as an example), and an interconnect board (the interconnect board 5 as an example) that is electrically connected to the base board via the bonding material. The base board includes a first core base member (the first core base member 10 as an example), a first organic base member (the first organic base member 20 as an example) that is bonded to the first core base member and is made of an organic resin, and a plurality of first wiring lines (the first wiring line 43 as an example) that are located inside the first organic base member. The interconnect board includes a second organic base member (the second organic base member 60 as an example) that is made of an organic resin, and a plurality of second wiring lines (the second wiring line 83 as an example) that are located inside the second organic base member. The second wiring line includes a diffusion suppression layer on a side surface of the second wiring line.
(2) In the composite wiring board according to (1) given above, the first wiring line and the second wiring line may contain copper as a main component, and the bonding material may contain at least one selected from the group consisting of Ag, Bi, In, Cu, and Sb, and Sn.
(3) In the composite wiring board according to (1) or (2) given above, the diffusion suppression layer may contain any one of Cr, Ti, Ni, and a compound obtained by combining two or more of Cr, Ti, and Ni.
(4) In the composite wiring board according to any one of (1) to (3) given above, a side surface of the first wiring line may directly contact with the first organic base member.
(5) In the composite wiring board according to any one of (1) to (4) given above, the interconnect board may include a second core base member (the second core base member 50 as an example), and the second organic base member may be bonded to the second core base member.
(6) In the composite wiring board according to any one of (1) to (5) given above, the first core base member may be made of ceramic.
(7) In the composite wiring board according to (6) given above, the first core base member may include a plurality of ceramic layers (the ceramic layer 11 as an example).
(8) The composite wiring board according to (6) or (7) given above may include two first organic base members. The first core base member may include a first surface (the first surface 101 as an example) and a second surface (the second surface 102 as an example) that is located opposite to the first surface, and the first organic base members may be bonded to each of the first surface and the second surface.
(9) The composite wiring board according to (8) given above may include a conductor (the conductor 32 as an example) that penetrates the first surface and the second surface of the first core base member. The first wiring line located in the first organic base member bonded to the first surface and the first wiring line located in the first organic base member bonded to the second surface may be electrically connected via the conductor.
(10) In the composite wiring board according to any one of (6) to (9) given above, the first core base member may contain a glass component, and the first organic base member may contain a coupling agent that is chemically bonded to the glass component.
(11) A semiconductor device may include a mother board (the mother board 1 as an example), the composite wiring board according to any one of (1) to (10) given above, the composite wiring board being mounted over the mother board, and a semiconductor element mounted over the interconnect board.

The embodiments disclosed herein are to be considered exemplary in all respects and not restrictive. The embodiments described above may be embodied in various forms. The above-described embodiments may be omitted, substituted or modified in various forms without departing from the scope and spirit of the appended claims.

### REFERENCE SIGNS

1 Mother board
2 Composite wiring board
3 Semiconductor element
4 Base board
5 Interconnect board
10 First core base member
20 First organic base member
30 First conductor portion
40 Second conductor portion
43 First wiring line
50 Second core base member
60 Second organic base member
70 Third conductor portion
80 Fourth conductor portion
83 Second wiring line
100 Semiconductor device

## Claims

1. A composite wiring board comprising:
a base board;
a bonding material of a melting-point-change type; and
an interconnect board that is electrically connected to the base board via the bonding material, wherein
the base board comprises:
a first core base member;
a first organic base member that is bonded to the first core base member and is made of an organic resin; and
a plurality of first wiring lines that are located inside the first organic base member,
the interconnect board comprises:
a second organic base member that is made of an organic resin; and
a plurality of second wiring lines that are located inside the second organic base member, and
the second wiring line comprises a diffusion suppression layer on a side surface of the second wiring line.

2. The composite wiring board according to claim 1, wherein
the first wiring line and the second wiring line contain copper as a main component, and
the bonding material contains at least one selected from the group consisting of Ag, Bi, In, Cu, and Sb, and Sn.

3. The composite wiring board according to claim 1 or 2, wherein
the diffusion suppression layer contains any one of Cr, Ti, Ni, and a compound obtained by combining two or more of Cr, Ti, and Ni.

4. The composite wiring board according to any one of claims 1 to 3, wherein
a side surface of the first wiring line directly contacts with the first organic base member.

5. The composite wiring board according to any one of claims 1 to 4, wherein
the interconnect board comprises a second core base member, and
the second organic base member is bonded to the second core base member.

6. The composite wiring board according to any one of claims 1 to 5, wherein
the first core base member is made of ceramic.

7. The composite wiring board according to claim 6, wherein
the first core base member comprises a plurality of ceramic layers.

8. The composite wiring board according to claim 6 or 7, comprising:
two first organic base members, wherein
the first core base member comprises:
a first surface; and
a second surface that is located opposite to the first surface, and
the first organic base members are bonded to each of the first surface and the second surface.

9. The composite wiring board according to claim 8, comprising:
a conductor that penetrates the first surface and the second surface of the first core base member, wherein
the first wiring line located in the first organic base member bonded to the first surface and the first wiring line located in the first organic base member bonded to the second surface are electrically connected via the conductor.

10. The composite wiring board according to any one of claims 6 to 9, wherein
the first core base member contains a glass component, and
the first organic base member contains a coupling agent that is chemically bonded to the glass component.

11. A semiconductor device comprising:
a mother board;
the composite wiring board according to any one of claims 1 to 10, the composite wiring board being mounted over the mother board; and
a semiconductor element mounted over the interconnect board.
